# EUROPÄISCHE PATENTSCHRIFT

(11) **EP 0 560 067 B1**
(45) Veröffentlichungstag und Bekanntmachung des Hinweises auf die Patenterteilung: **04.10.1995**
(21) Anmeldenummer: 93102005.1
(22) Anmeldetag: 09.02.1993
(51) Int. Cl.: H05K 7/14

(54) **Gehäusesystem**
Housing system
Système de boîtier

(30) Priorität: 13.03.1992 DE 4208176
(43) Veröffentlichungstag der Anmeldung: 15.09.1993
(73) Patentinhaber: VERO Electronics GmbH, D-28279 Bremen (DE)
(72) Erfinder: Hornung, Gerhard, W-2878 Wildeshausen (DE); Bösch, Peter, W-2800 Bremen 61 (DE); Borschewski, Dietmar, W-2800 Bremen 1 (DE)
(74) Vertreter: Bohnenberger, Johannes, Dr.

(56) Entgegenhaltungen:
- GB-A- 2 065 378
- US-A- 4 702 535

## Beschreibung

Die Erfindung betrifft ein Gehäusesystem, nämlich ein 19˝ Gehäusesystem nach dem Oberbegriff des Patentanspruches 1.

Hierbei sei betont, daß es sich insgesamt um genormte Systeme handelt, bei denen Baugruppen bzw. Bauteile einer nationalen oder internationalen Normung unterliegen und darum nur in bestimmten Größenabmessungen verwendbar sind. Diese Größenabmessungen sind z. B. bestimmt in der DIN 41 494 bzw. IEC 297-1/2/3.

Nach diesen Normen aufgebaute Geräte umfassen beispielsweise eine gewisse Anzahl von elektronischen Baugruppen, die in einen Baugruppenträger eingesteckt werden. Der Baugruppenträger wiederum kann in ein Außengehäuse oder einen Schrank bzw. ein Laborgestell eingebaut oder eingeschoben werden.

Bei derartigen Geräten besteht nun das Problem, daß dann, wenn man ein Gerät aus elektronischen Baugruppen mit einer Stecktiefe von z. B. 160 mm aufgebaut hat, der in einem Schrank gemäß Norm zur Verfügung stehende Platz (hinsichtlich seiner Tiefe) nur zu einem Bruchteil ausgenutzt ist.

Weiterhin besteht das Problem, daß man einen mit elektronischen Baugruppen bestückten Baugruppenträger zwar in ein Außengehäuse einsetzen kann, dieses Außengehäuse aber nicht mehr in einen Schrank paßt.

Aus der US-A- 4 702 535 ist ein Gehäusesystem nach dem Oberbegriff des Patentanspruches 1 bekannt, dessen Außengehäuse eine offene Frontseite und einen Innenraum aufweist, in welchen Baugruppenträger mit daran befindlichen Frontplatten einschiebbar sind. Die Einschubrichtung erfolgt hierbei senkrecht zur Ebene der Baugruppenträger-Frontplatten, so daß dann, wenn der Baugruppenträger vollständig mit Baugruppen bestückt ist, deren Frontplatten eine Ebene bilden und die Frontöffnung des Außengehäuses verschließen. Im wesentlichen entspricht dies der eingangs beschriebenen Lösung, bei welcher die elektronischen Baugruppen als Kassetten mit Frontplatten ausgebildet sind.

Der Erfindung liegt die Aufgabe zugrunde, ein Gehäusesystem der eingangs genannten Art dahingehend weiterzubilden, daß in einfacher Weise dessen Variabilität und die erzielbare Packungsdichte vergrößert werden.

Diese Aufgabe wird durch die im Patentanspruch 1 angegebenen Merkmale gelöst.

Ein wesentlicher Punkt der Erfindung liegt darin, daß man bei Anwendung der vorliegenden Erfindung in ein Außengehäuse zwei voll bestückte Baugruppenträger einschieben kann und dieses Außengehäuse entweder separat (sozusagen als äußerste Hülle) verwenden, oder aber in einen Schrank einbauen kann, wobei lediglich das Außengehäuse und der Baugruppenträger aufeinander abgestimmt sein müssen. die Außenabmessungen des Außengehäuses ebenso wie die "Innenabmessungen" des Baugruppenträgers sind der Norm angepaßt.

Vorzugsweise sind Führungseinrichtungen vorgesehen, um die (zwei) Baugruppenträger im Außengehäuse zu halten und das Hineinschieben und Herausziehen derselben zu erleichtern. Diese Führungseinrichtungen sind im Bereich zwischen Vorderseiten der Frontplatten (wenn die elektronischen Baugruppen mit solchen versehen sind) und Rückseiten der Mutterplatten (wenn solche vorgesehen sind) angebracht, also im Bereich zwischen den (normgemäßen) Mindest-Außenabmessungen eines bestückten Baugruppenträgers.

Hierbei ist es möglich, die Führungseinrichtungen so auszugestalten, daß sie "direkt" die Frontplatten aufnehmen bzw. in ihre Führungsfunktion mit einbeziehen. Gleiches gilt für die Mutterplatten. Die Führungseinrichtungen selbst können als einfache Gleitführungen, oder aber als Rollenführungen, ggf. auch als Teleskopschienen-Führungen ausgebildet sein.

Damit das Außengehäuse in seinen Außenabmessungen normgemäß ausgebildet, also in einen Schrank einbaubar ist, wird es im Bereich der Frontplatten bzw. Mutterplatten mit im wesentlichen einfacher Materialstärke (max. 1,6 mm) eines Gehäuse - Deckels bzw. -Bodens ausgebildet.

Außerhalb eines Einschubraumes für Frontplatten bzw. Mutterplatten werden vorzugsweise im Außengehäuse in dessen Innenraum ragende Innenelemente vorgesehen, die (ggf. gleichzeitig) verschiedene Funktionen ausüben können. Derartige Innenelemente können als Hohlkörper ausgebildet sein, so daß sie als Lüftungskanäle Verwendung finden können, oder aber elektronischen Funktionseinrichtungen, z. B. Netzgeräten oder dgl. zur Aufnahme dienen. Insbesondere können aber derartige elektronische Funktionseinrichtungen auch zusätzlich in den Innenraum des Außengehäuses ragend an diesem befestigt sein. Weiterhin ist es möglich, wärmeaufnehmende Elemente (heatpipes) vorzusehen, welche die von den elektronischen Baugruppen erzeugte Wärme aus dem Außengehäuse transportieren. Die Baugruppenträger wiederum sind im Bereich der Innenelemente mit einer gegenüber Frontplatten oder Mutterplatten verringerten Höhe ausgebildet, also im wesentlichen umgekehrt (konkav) geformt, als dies bei den bisher üblichen Baugruppenträgern mit nach außen hervorspringenden (konvexen) bzw. über die Ober- und Unterkanten der Frontplatten oder Mutterplatten hinausstehende Dekkel- und Bodenflächen praktiziert wurde.

Die Führungen sind vorzugsweise derart im Außengehäuse angebracht, daß die Baugruppenträger auch dann einschiebbar sind, wenn sie mit Baugruppen bestückt sind, welche Griffe an Ihren Frontplatten (soweit vorhanden) aufweisen. Dies hat den besonderen Vorteil, daß beim Anwender schon vorhandene oder von anderen Herstellern angebotene elektronische Baugruppen verwendbar und zu Einstell- oder Reperaturzwecken leicht aus den Baugruppenträgern entfernbar sind.

Im Außengehäuse, insbesondere an einer rückwertigen Innenwand des Außengehäuses sind Gehäuse-Steckverbindungseinrichtungen vorgesehen, die so ausgebildet sind, daß sie mit korrespondierenden Baugruppenträger-Steckverbindungseinrichtungen an den Baugruppenträgern verbindbar sind. Diese Steckverbindungen können nun so ausgebildet sein, daß die Baugruppenträger aus dem Außengehäuse im wesentlichen vollständig herausgezogen werden können, ohne daß die elektrische Verbindung unterbrochen wird. Somit sind die einzelnen Baugruppen z. B. an ihren Frontplatten zugänglich, so daß der Anwender notwendige Einstell- oder Überwachungsmaßnahmen im aktiven Zustand der Baugruppen treffen kann. Dabei stehen ihm unter anderem auch die ggf. an den Frontplatten der elektronischen Baugruppen vorgesehenen Einstell- oder Anzeigeelemente zur Verfügung. Weiterhin können die elektronischen Baugruppen beispielsweise über in den Frontplatten vorgesehene Steckbuchsen mit Testgeräten oder dgl. verbunden werden.

Das Außengehäuse wird vorzugsweise derart ausgebildet, daß bei eingeschobenen Baugruppenträgern die elektronischen Baugruppen im wesentlichen vollständig IP- und/oder EMV- abgeschirmt schirmt sind. Dies bedeutet, daß der Anwender nicht mehr - wie bisher - jede einzelne elektronische Baugruppe mit großem Aufwand abschirmen muß, da diese Aufgabe dem Außengehäuse zufällt. Dies ist insofern besonders bedeutsam, als die elektronischen Baugruppen mit ihren einzelnen, voneinander getrennten Frontplatten auch bei Einbau in ein sonst übliches Gehäuse Spaltöffnungen freilassen, durch welche Störstrahlen gelangen können. Dadurch aber, daß gemäß der vorliegenden Erfindung alle elektronischen Baugruppen samt ihrer Frontplatten im Außengehäuse aufgenommen sind, kann mit einer einzigen Abschirmung jegliches Eindringen (oder herausdringen) von Störstrahlung verhindert werden.

Hierzu wird die Einschuböffnung des Außengehäuses über eine Außen-Frontplatte verschlossen. Diese kann nun als separates Teil am Außengehäuse befestigt, z. B. angelenkt sein. Es ist aber auch möglich, die Frontplatte durch Seitenteile der Baugruppenträger zu bilden oder aber die Frontplatte an einem der Seitenteile der Baugruppenträger zu befestigen. Wird die Frontplatte mit den Seitenteilen von zwei eingeschobenen Baugruppenträgern verbunden, so kann man diese gemeinsam aus dem Außengehäuse herausziehen. Besonders in diesem Fall wird man vorzugsweise einen Aufbau wählen, bei welchem die Frontplatten-Seiten beider Baugruppenträger entweder nach außen oder nach innen gewandt sind.

Weitere Merkmale und bevorzugte Ausführungsformen der Erfindung ergeben sich aus den Unteransprüchen und der nachfolgenden Beschreibung bevorzugter Ausführungsformen der Erfindung, die anhand von Abbildungen näher erläutert werden. Hierbei zeigen
- Fig. 1 - 3: Querschnitte durch verschiedene Ausführungsformen des erfindungsgemäßen Systems,
- Fig. 4: eine Seitenansicht eines Außengehäuses mit herausgezogenem Baugruppenträger,
- Fig. 5: eine Draufsicht auf die Anordnung nach Fig. 4,
- Fig. 6: eine teil-geschnittene Draufsicht auf ein, in einen Schrank eingebautes System,
- Fig. 7: das System nach Fig. 6 mit herausgezogenen Baugruppenträgern, und
- Fig. 8: eine Ansicht ähnlich der nach Fig. 6 mit einem Gehäuse, das mit gemischten Baugruppenträgern bestückt ist.

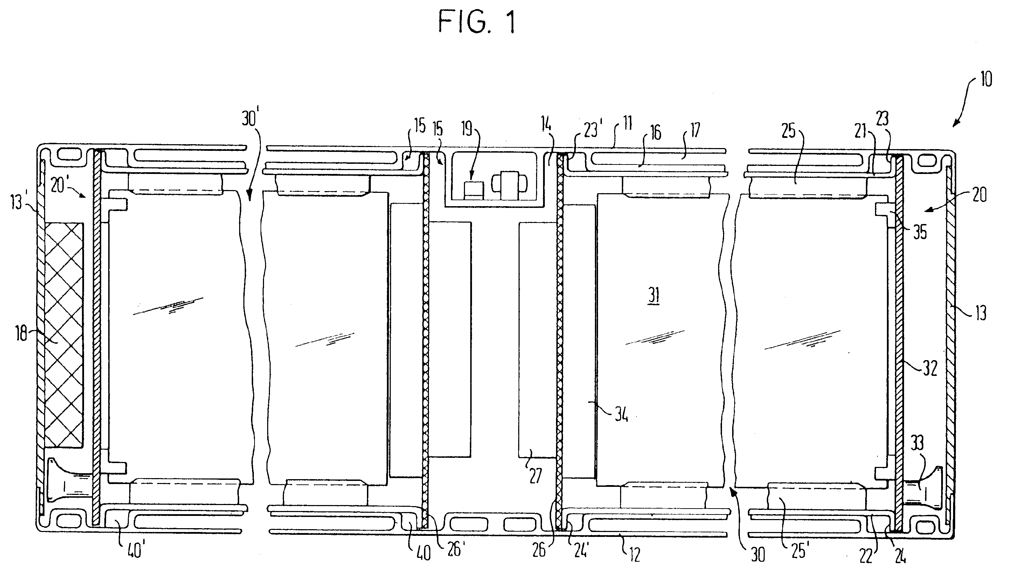

Bei der in Fig. 1 gezeigten Ausführungsform der Erfindung ist ein Außengehäuse 10 gezeigt, dessen Deckel 11 und Boden 12 als (Aluminium-) Strangpreßprofile ausgebildet sind. der Deckel 11 und der Boden 12 sind über Seitenteile 13, 13′ miteinander verbunden. Auf diese Weise umschließt das Außengehäuse 10 einen Innenraum 14.

Der Deckel 11 und der Boden 12 weisen in den Innenraum 14 vorspringende Innenelemente 15 auf, welche als Lüftungskanäle 17 verwendbar sind, wobei durch die Doppel-Schichtigkeit des Deckels 11 bzw. Bodens 12 in diesem Bereich gleichzeitig eine Versteifung 16 des Außengehäuses 10 erzielbar ist.

Bei der in Fig. 1 gezeigten Ausführungsform ist eines der Innenelemente 15 (oben in der Mitte) als Funktionseinrichtung 19 ausgebildet, beherbergt z. B. also ein Netzteil oder dgl. Einrichtung.

Das in Fig. 1 gezeigte System umfaßt weiterhin zwei einschiebbare Baugruppenträger 20, 20′, die jeweils einen Deckel 21 und einen Boden 22 haben, die durch (nicht gezeigte) Seitenteile verbunden sind. Der Deckel 21 und der Boden 22 weisen jeweils nach außen ragende Flansche 23, 23′ bzw. 24, 24′ auf, sind also in ihrem mittleren Abschnitt "schlanker" als an ihren Enden nämlich den Außenrändern der Flansche 23, 24.

An den Innenflächen eines jeden Deckels 21 bzw. Bodens 22 sind Führungsschienen 25, 25′ in der an sich bekannten Weise befestigt, die zur Aufnahme von Platinen 31 (wie in Fig. 1 gezeigt) der Baugruppen 30 oder aber auch zur Aufnahme von Kassetten gemäß Norm dienen.

Wenn die Baugruppen 30 mit Frontplatten 32 versehen sind, die z. B. über Winkel 35 an einer Platine 31 befestigt sein können, so liegen diese Frontplatten 32 auf den Flanschen 23/24 an, wobei die Flansche 23, 24 so ausgebildet sind, daß ihre Ober- bzw. Unterkanten bündig mit den jeweiligen Ober- bzw. Unterkanten der Frontplatten 32 velaufen. Gleichen gilt für Mutterplatten 26, die am rückwertigen Ende eines jeden Baugruppenträgers 20, 20′ an diesem (an den Flanschen 23′/24′) angebracht sein können.

Solche Mutterplatten 26 sind (üblicherweise) mit Buchsenleisten 27 versehen, in welche Steckerleisten 34 von elektronischen Baugruppen 30 einsteckbar sind.

Bei der in Fig. 1 gezeigten Ausführungsform der Erfindung sind die Innenelemente 15 nun derart angebracht, daß sie bzw. einige von ihnen gleichzeitig eine Art von Führungseinrichtungen 40, 40′ bilden. Hierbei sind der Deckel 11 und der Boden 12 in dem Bereich, in welchem bei eingeschobenen Baugruppenträgern 30 die Mutterplatten 26 bzw. die Frontplatten 32 zu liegen kommen, also auch die Flansche 23, 24 sich befinden, nur noch sehr dünn (einfache Blechstärke) ausgebildet. Geht man von der 19˝ Norm aus, so errechnet sich die Wandstärke von Deckel und Boden in diesem Bereich zu jeweils 1,6 mm (maximal).

Bei der in Fig. 1 gezeigten Ausführungsform ist (der Vollständigkeit halber) am linken Seitenteil 13′ ein wärmeaufnehmendes Element 18 gezeigt, das die von der hier gezeigten linken elektronischen Baugruppe 30′ erzeugte Wärme durch das Seitenteil 13′ nach außen abführen kann.

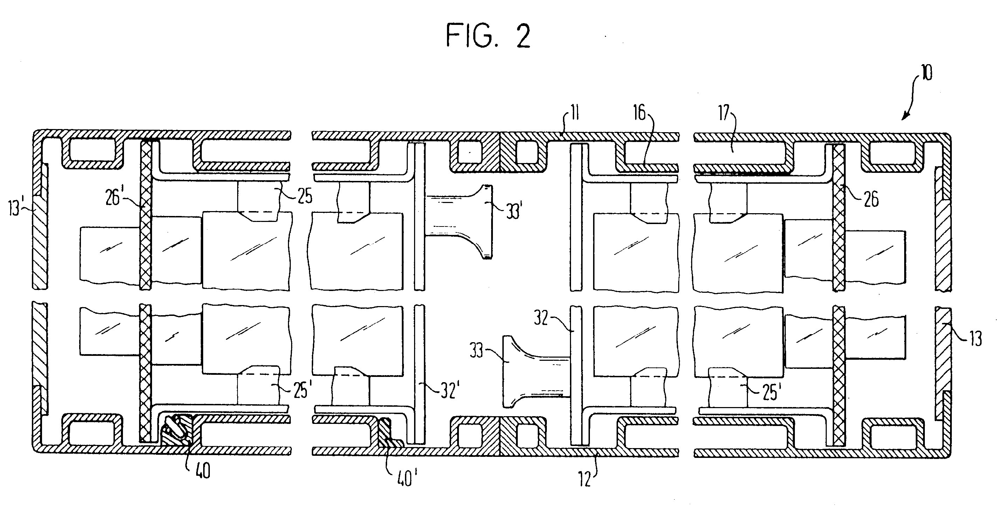

Die in Fig. 2 gezeigte Ausführungsform der Erfindung unterscheidet sich von der nach Fig. 1 durch die dort aufwendiger ausgestalteten Führungseinrichtungen 40, 40′, die entweder als Rollenführungen (40) oder aber als einfacherere Gleitführungen (40′) aus entsprechendem Kunststoffmaterial ausgebildet sein können.

Darüber hinaus ist in Fig. 2 gezeigt, daß man die Baugruppenträger 20 auch derart einbauen kann, daß die darin enthaltenen elektronischen Baugruppen 30, 30′ mit ihren Frontplatten 32, 32′ einander zugewandt liegen, wobei einmal deren Griffe 33′ oben und einmal deren Griffe 33 unten angeordnet sind, wodurch eine Platzersparnis erzielbar ist. Dies gilt insbesondere dann, wenn man - anders als in Fig. 2 - die Griffe 33, 33′ einander überlappend anordnet.

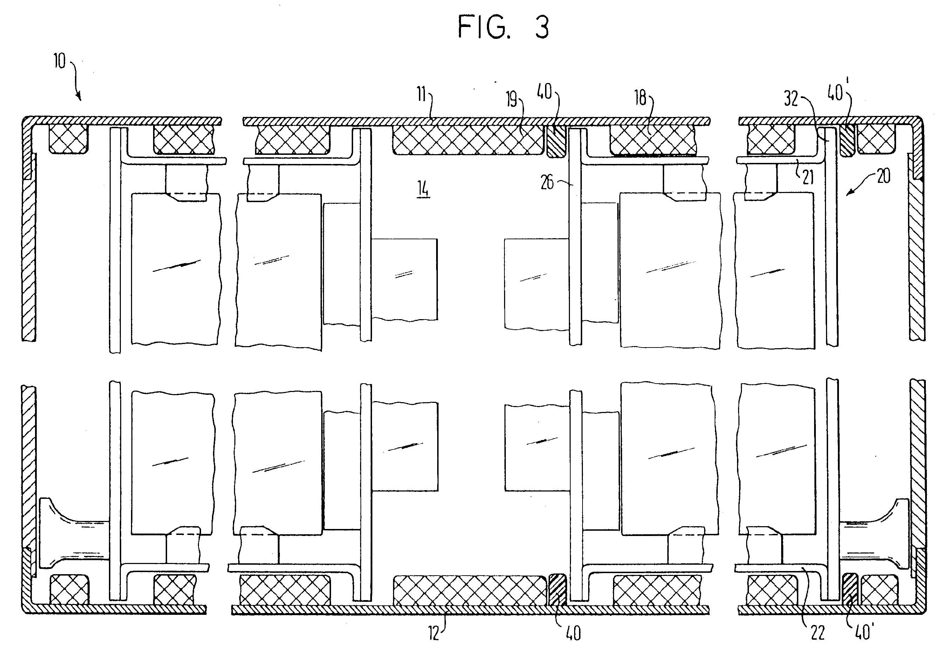

Bei der in Fig. 3 gezeigten bevorzugten Ausführungsform sind die Führungen 40, 40′ derart angeordnet, daß sie den Baugruppenträgern in Horizontalrichtung dadurch Halt verleihen, daß sie an den Außenflächen der Frontplatten 32 bzw. Mutterplatten 26 anliegen.

Weiterhin unterscheidet sich die in Fig. 3 gezeigte Ausführungsform von den zuvor gezeigten Ausführungsformen dadurch, daß eine Vielzahl von wärmeaufnehmenden Elementen 18 (z. B. heatpipes oder dgl.) als Innenelemente 15 vorgesehen sind, um die Wärme aus dem Innenraum 14 des Außengehäuses 10 durch den Deckel 11 bzw. Boden 12 zu transportieren. Besonders effektiv sind hierbei die wärmeaufnehmenden Elemente 18, welche direkt über bzw. unter dem Deckel 21 bzw. dem Boden 22 der Baugruppenträger 20, 20′ angeordnet sind.

Der Vollständigkeit halber sei auch erwähnt, daß die Seitenteile 13, 13′ des Außengehäuses 10 Bohrungen zum Anbringen von Haltewinkeln aufweisen können, um das Außengehäuse 10 in einem Schrank zu befestigen. Hierbei können die Seitenteile auch gemäß DE 40 11 074 A1 mit klappbaren Haltewinkeln ausgestattet sein.

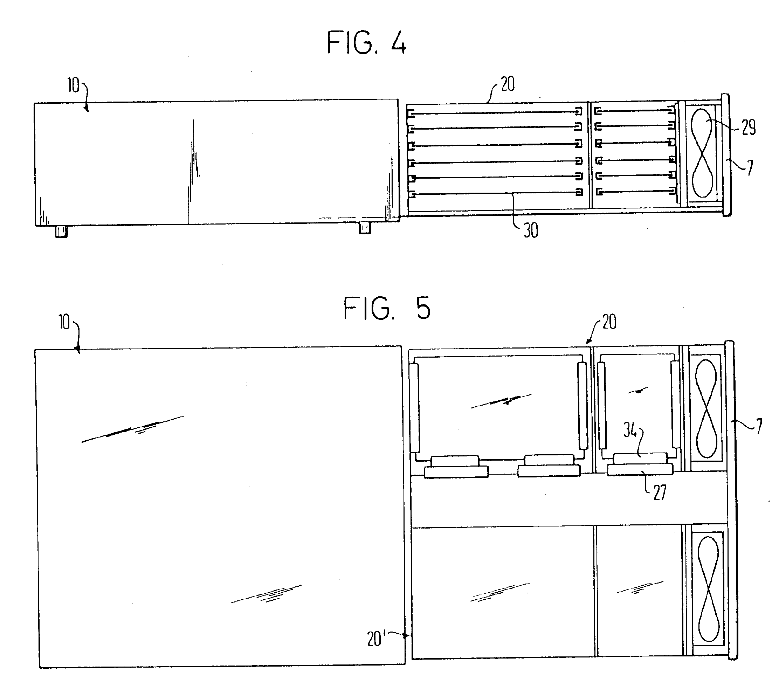

Wie in den Fig. 4 und 5 gezeigt, ist es auch möglich, die Baugruppenträger 20 nicht mit vertikal angeordneten, sondern mit horizontal angeordneten Platinen bzw. Baugruppen 30 auszurüsten. Diese können weiterhin in mehreren Reihen gestaffelt sein, wie dies an sich allgemein bekannt ist. Weiterhin ist es möglich, am Seitenteil der Baugruppenträger Lüfter 29 unterzubringen, welche Luft (ggf. durch ein Filter) von außen ansaugen und zur Wärmeabgabe nach außen wieder abgeben.

Bei der in den Figuren 4 und 5 gezeigten Ausführungsform der Erfindung sind die Seitenteile der dort gezeigten zwei Baugruppenträger 20, 20′ jeweils mit einer Außenfrontplatte 7 verbunden, welche bei eingeschobenen Baugruppenträgern 20, 20′ das Außengehäuse 10 vollständig verschließen, um so eine IP-, EMP- Abschirmung sicherzustellen. Bei dieser Variante werden somit beide Baugruppenträger 20, 20′ gleichzeitig in das Außengehäuse 10 eingeschoben bzw. aus diesem herausgezogen. Selbstverständlich ist es auch möglich, die Frontplatte 7 zu teilen - dann kann man beide Baugruppenträger voneinander getrennt herausziehen - oder nur an einem der Baugruppenträger 20 oder 20′ zu befestigen, wobei die Befestigung vorzugsweise an dem Baugruppenträger geschieht, der mit größerer Warscheinlichkeit zugänglich gemacht werden muß.

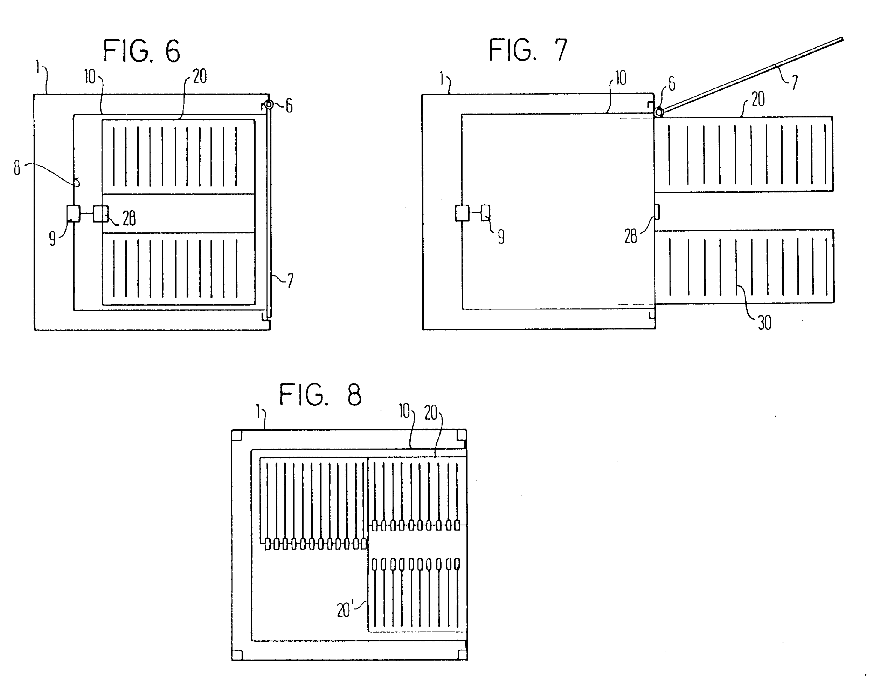

Bei der in den Figuren 6 und 7 gezeigten Ausführungsformen der Erfindung ist die Außenfrontplatte 7 über ein Scharniergelenk 6 am Außengehäuse 10 befestigt. Darüberhinaus sind bei dieser Ausführungsform an der Innenwand 8 des Außengehäuses 10 Gehäusesteckverbinder 9 vorgesehen, die mit entsprechend ausgebildeten Baugruppensteckverbindern 28 beim Einschieben der selben in Kontakt gelangen können. Das Außengehäuse 10 ist hierbei in einen Schrank 1 eingesetzt. Aus den Figuren 6 und 7 wird ersichtlich, daß exakt die doppelte Menge an Baugruppenträgern 20 auf einer "Etage" eines Schrankes 1 Platz findet, als dies bisher üblich war.

Wie in Fig. 8 gezeigt, können die Baugruppenträger 20, 20′ auch in "gemischter Bauweise" ausgebildet sein, also gestaffelt bzw. ineinander "verzahnt" ausgebildet werden.

### Bezugszeichenliste

- 1: Schrank
- 6: Anlenkung
- 7: Außenfrontplatte
- 8: Innenwand
- 9: Gehäusesteckverbindungseinrichtung
- 10: Außengehäuse
- 11: Deckel
- 12: Boden
- 13: Seitenteil
- 14: Innenraum
- 15: Innenelement
- 16: Versteifung
- 17: Lüftungskanal
- 18: wärmeaufnehmendes Element
- 19: Funktionseinrichtung
- 20: Baugruppenträger
- 21: Deckel
- 22: Boden
- 23: Flansch
- 24: Flansch
- 25: Führungsschiene
- 26: Mutterplatte
- 27: Buchsenleiste
- 28: Baugruppenträgersteckverbindungseinrichtung
- 29: Lüfter
- 30: Baugruppe
- 31: Platine
- 32: Frontplatte
- 33: Griff
- 34: Steckerleiste
- 35: Befestigungswinkel
- 40: Führungseinrichtung

## Patentansprüche

1. Gehäusesystem, insbesondere 19˝-Gehäusesystem zur Aufnahme elektronischer Baugruppen (30) mit mindestens einem Baugruppenträger (20, 20′), in welchen die elektronischen Baugruppen, insbesondere 19˝-Baugruppen, welche jeweils eine Frontplatte (32) aufweisen können, einschiebbar sind, und mit einem Außengehäuse (10), insbesondere einem 19˝-Außengehäuse mit offener Frontseite zur Aufnahme des mindestens einen Baugruppenträgers (20, 20′)
**dadurch gekennzeichnet,**
daß das Außengehäuse (10) einen derart ausgebildeten Innenraum (14) und eine offene Frontseite aufweist, daß mindestens zwei Baugruppenträger (20, 20′) mit eingeschobenen Baugruppen (30) und daran angebrachten Frontplatten (32) und/oder Mutterplatten (26) mit ihren Frontplatten (32) quer zur Frontseite in das Außengehäuse (10) einschiebbar sind.

2. Gehäusesystem nach Anspruch 1,
dadurch gekennzeichnet, daß Führungseinrichtungen (40, 40′) zum Führen und Halten der Baugruppenträger (20) im Außengehäuse (10) vorgesehen sind.

3. Gehäusesystem nach Anspruch 2,
dadurch gekennzeichnet, daß die Führungseinrichtungen (40, 40′) im Bereich zwischen Vorderseiten der Frontplatten (32) und Rückseiten der Mutterplatten (26) vorgesehen sind.

4. Gehäusesystem nach einem der Ansprüche 2 oder 3,
dadurch gekennzeichnet, daß die Führungseinrichtungen (40, 40′) zur Aufnahme von Frontplatten (32) ausgebildet sind.

5. Gehäusesystem nach einem der Ansprüche 2 bis 4,
dadurch gekennzeichnet, daß die Führungseinrichtungen (40, 40′) zur Aufnahme von Mutterplatten (26) ausgebildet sind, welche an der Rückseite der Baugruppenträger (20) montiert sind.

6. Gehäusesystem nach einem der vorhergehenden Ansprüche,
dadurch gekennzeichnet, daß das Außengehäuse (10) außerhalb eines Einschubraumes für Frontplatten (32) und/oder Mutterplatten (26) der elektronischen Baugruppen (30) in den Innenraum (14) ragende Elemente (15) nämlich Versteifungen (16) und/oder wärmeaufnehmende Elemente (18), insbesondere Wärmetauscher, Lüftungskanäle (17) oder Lüfter und/oder elektronische Funktionseinrichtungen (19), insbesondere Netzgeräte oder dgl. aufweist, und daß die Baugruppenträger (20) im Bereich der Innenelemente (15) mit einer gegenüber Frontplatten (32) und/oder Mutterplatten (26) vermingerten Höhe ausgebildet sind.

7. Gehäusesystem nach einem der Ansprüche 2 bis 6,
dadurch gekennzeichnet, daß die Führungen (40, 40′) derart im Außengehäuse (10) angebracht sind, daß Baugruppen (30) mit Griffen (33) an Frontplatten (32) einsetzbar sind.

8. Gehäusesystem nach einem der vorhergehenden Ansprüche,
dadurch gekennzeichnet, daß im Außengehäuse (10) insbesondere an einer rückwertigen Innenwand (8) Gehäusesteckverbindungseinrichtungen (9) vorgesehen und so ausgebildet sind, daß sie mit korrespondierenden Baugruppenträgersteckverbindungseinrichtungen (28) an den Baugruppenträgern (20) verbindbar sind.

9. Gehäusesystem nach Anspruch 8,
dadurch gekennzeichnet, daß die Steckverbindungseinrichtungen (9, 28) derart ausgebildete Kabeleinrichtungen umfaßen, daß die Baugruppenträger (20) aus dem Außengehäuse (10) unter Beibehaltung der elektrischen Verbindung zur Zugänglichmachung der Baugruppen (30) im wesentlichen vollständig herausziehbar sind.

10. Gehäusesystem nach einem der vorhergehenden Ansprüche,
dadurch gekennzeichnet, daß das Außengehäuse (10) bei eingeschobenen Baugruppenträgern (20) im wesentlichen vollständig IP- und/oder EMV-abgeschirmt ist.

11. Gehäusesystem nach Anspruch 10,
dadurch gekennzeichnet, daß das Außengehäuse (10) eine öffenbare Außenfrontplatte (7) umfaßt.

12. Gehäusesystem nach Anspruch 11,
dadurch gekennzeichnet, daß die Außenfrontplatte (7) am Außengehäuse (10) befestigt, vorzugsweise angelenkt (6) ist.

13. Gehäusesystem nach einem der Ansprüche 11 oder 12,
dadurch gekennzeichnet, daß die Außenfrontplatte (7) wenigstens abschnittsweise von mindestens einem Seitenteil eines Baugruppenträgers (20) gebildet ist.

14. Gehäusesystem nach einem der Ansprüche 11 oder 12,
dadurch gekennzeichnet, daß die Frontplatte (7) separat ausgebildet und mit mindestens einem Seitenteil eines Baugruppenträgers (20) verbunden ist.

15. Gehäusesystem nach einem der vorhergehenden Ansprüche,
dadurch gekennzeichnet, daß das Außengehäuse (10) im Bereich der Frontplatten (32) und/oder Mutterplatten (26) mit im wesentlichen einfacher Materialstärke eines Gehäusedeckels (11) bzw. Bodens (12) ausgebildet ist.

16. Gehäusesystem nach Anspruch 15,
dadurch gekennzeichnet, daß die einfache Materialstärke unter 1,6 mm beträgt.

## Claims

1. Housing system, in particular a 19˝ housing system for receiving electronic modules (30), having at least one mounting rack (20, 20′) into which the electronic modules, in particular 19˝ modules which may each have a front panel (32), are insertable and having an outer housing (10), in particular a 19˝ outer housing with an open front side for receiving the at least one mounting rack (20, 20′),
characterized in that
the outer housing (10) has an open front side and an interior (14) designed in such a way that at least two mounting racks (20, 20′) with inserted modules (30) and fitted front panels (32) and/or mother boards (26) are insertable with their front panels (32) at right angles to the front side into the outer housing (10).

2. Housing system according to claim 1,
characterized in that
guide devices (40, 40′) are provided for guiding and retaining the mounting racks (20) in the outer housing (10).

3. Housing System according to claim 2,
characterized in that
the guide devices (40, 40′) are provided in the region between the front sides of the front panels (32) and the rear sides of the mother boards (26).

4. Housing system according to one of claims 2 or 3,
characterized in that
the guide devices (40, 40′) are designed so as to receive front panels (32).

5. Housing system according to one of claims 2 to 4,
characterized in that
the guide devices (40, 40′) are designed so as to receive mother boards (26) which are mounted at the rear of the mounting racks (20).

6. Housing system according to one of the preceding claims,
characterized in that
the outer housing (10) outside of an insertion space for front panels (32) and/or mother boards (26) of the electronic modules (30) has elements (15) which project into the interior (14), namely stiffening elements (16) and/or heat-absorbing elements (18), in particular heat exchangers, ventilation channels (17) or fans and/or electronic function devices (19), in particular power packs or the like, and that the mounting racks (20) in the region of the internal elements (15) are constructed with a reduced height compared to the front panels (32) and/or the mother boards (26).

7. Housing system according to one of claims 2 to 6,
characterized in that
the guides (40, 40′) are fitted in the outer housing (10) in such a way as to enable the insertion of modules (30) with handles (33) on the front panels (32).

8. Housing system according to one of the preceding claims,
characterized in that
housing connector devices (9) are provided in the outer housing (10), particularly at a rear inner wall (8), and are so designed that they are connectable to corresponding mounting rack connector devices (28) on the mounting racks (20).

9. Housing system according to claim 8,
characterized in that
the connector devices (9, 28) comprise cable devices designed in such a way that the mounting racks (20) are withdrawable substantially fully out of the outer housing (10) to allow access to the modules (30), while maintaining the electrical connection.

10. Housing system according to one of the preceding claims,
characterized in that
the outer housing (10), when the mounting racks (10) are inserted, is substantially fully IP- and/or EMC-shielded.

11. Housing system according to claim 10,
characterized in that
the outer housing (10) comprises an openable outer front panel (7).

12. Housing system according to claim 11,
characterized in that
the outer front panel (7) is fastened, preferably hinged (6), on the outer housing (10).

13. Housing system acccording to one of claims 11 or 12,
characterized in that
the outer front panel (7) at least in sections is formed by at least one side part of a mounting rack (20).

14. Housing system according to one of claims 11 or 12,
characterized in that
the front panel (7) is constructed separately and is connected to at least one side part of a mounting rack (20).

15. Housing system according to one of the preceding claims,
characterized in that
the outer housing (10) in the region of the front panels (32) and/or mother boards (26) is constructed with substantially a single material thickness of a housing cover (11) or base (12).

16. Housing system according to claim 15,
characterized in that
the single material thickness is below 1.6 mm.

## Revendications

1. Système de boîtier, en particulier système de boîtier 19˝ pour le logement d'ensembles électroniques (30), comprenant au moins un châssis équipé (20, 20′) dans lequel peuvent être enfichés les ensembles électroniques, en particulier les ensembles 19˝, éventuellement munis chacun d'une plaque frontale (32), et un boîtier extérieur (10), en particulier un boîtier extérieur 19˝, avec face frontale ouverte, pour la réception d'au moins un châssis équipé (20, 20′), **caractérisé en ce** que le boîtier extérieur (10) présente un espace intérieur (14) et une face frontale ouverte conformés de telle façon qu'au moins deux châssis équipés (20, 20′) munis d'ensembles (30) enfichés et de plaques frontales (32) et/ou de cartes-mères (26) montées sur ces derniers, peuvent être insérés dans le boîtier extérieur (10), les plaques frontales (32) étant orientées transversalement à la face frontale.

2. Système de boîtier selon la revendication 1, caractérisé en ce qu'il comprend des dispositifs de guidage (40, 40′) pour le guidage et le maintien des châssis équipés (20) dans le boîtier extérieur (10).

3. Système de boîtier selon la revendication 2, caractérisé en ce que les dispositifs de guidage (40, 40′) sont prévus dans la région entre les faces avant des plaques frontales (32) et les faces arrières des cartes-mères (26).

4. Système de boîtier selon l'une des revendications 2 ou 3, caractérisé en ce que les dispositifs de guidage (40, 40′) sont agencés pour la réception de plaques frontales (32).

5. Système de boîtier selon l'une des revendications 2 à 4, caractérisé en ce que les dispositifs de guidage (40, 40′) sont agencés pour la réception de cartes-mères (26) montées sur la face arrière des châssis équipés (20).

6. Système de boîtier selon l'une quelconque des revendications précédentes, caractérisé en ce que le boîtier extérieur (10) présente, à l'extérieur d'un espace d'insertion pour des plaques frontales (32) et/ou des cartes-mères (26) des ensembles électroniques (30), des éléments (15) dépassant dans l'espace intérieur (14), à savoir des raidisseurs (16) et/ou des éléments endothermiques (18), en particulier des échangeurs de chaleur, des canaux de ventilation (17) ou des ventilateurs et/ou des dispositifs électroniques fonctionnels (19), en particulier des blocs d'alimentation ou analogues, et que les châssis équipés (20) présentent, dans la région des éléments intérieurs (15), une hauteur réduite par rapport aux plaques frontales (32) et/ou aux cartes-mères (26).

7. Système de boîtier selon l'une des revendications 2 à 6, caractérisé en ce que les guidages (40, 40′) sont prévus dans le boîtier extérieur (10) de telle façon que des ensembles (30) avec des poignées (33) sur des plaques frontales (32) peuvent être insérés.

8. Système de boîtier selon l'une quelconque des revendications précédentes, caractérisé en ce que dans le boîtier extérieur (10), en particulier sur une paroi intérieure postérieure (8) sont prévus des connecteurs à fiches (9) de boîtier qui sont réalisés de telle façon qu'ils peuvent être branchés avec des connecteurs à fiches (28) conjugués prévus sur les châssis équipés (20).

9. Système de boîtier selon la revendication 8, caractérisé en ce que les connecteurs à fiches (9, 28) comprennent des systèmes de câblage agencés de telle façon que les châssis équipés (20) peuvent sensiblement être retirés entièrement du boîtier extérieur (10) tout en conservant la liaison électrique, pour permettre l'accès aux ensembles (30).

10. Système de boîtier selon l'une quelconque des revendications précédentes, caractérisé en ce que, lorsque les châssis équipés (20) sont insérés, le boîtier extérieur (10) comporte un blindage IP et/ou EMV sensiblement complet.

11. Système de boîtier selon la revendication 10, caractérisé en ce que le boîtier extérieur (10) comprend une plaque frontale extérieure (7) ouvrable.

12. Système de boîtier selon la revendication 11, caractérisé en ce que la plaque frontale extérieure (7) est fixée, de préférence articulée (6), sur le boîtier extérieur (10).

13. Système de boîtier selon l'une des revendications 11 ou 12, caractérisé en ce que la plaque frontale extérieure (7) est constituée, au moins par sections, par au moins un élément latéral d'un châssis équipé (20).

14. Système de boîtier selon l'une des revendications 11 ou 12, caractérisé en ce que la plaque frontale (7) est séparée et rattachée à au moins un élément latéral d'un châssis équipé (20).

15. Système selon l'une quelconque des revendications précédentes, caractérisé en ce que le boîtier extérieur (10) présente sensiblement, dans la région des plaques frontales (32) et/ou des cartes-mères (26), l'épaisseur de matériau simple d'un couvercle (11) ou d'un fond (12) du boîtier.

16. Système de boîtier selon la revendication 15, caractérisé en ce que l'épaisseur de matériau simple est inférieure à 1,6 mm.
